# EUROPÄISCHE PATENTANMELDUNG

(11) **EP 2 086 029 A2**
(43) Veröffentlichungstag der Anmeldung: **05.08.2009**
(21) Anmeldenummer: 09100016.6
(22) Anmeldetag: 07.01.2009
(51) Int. Cl.: H01L 41/053, H01L 41/083, F02M 51/06

(54) **Piezoaktormodul und Piezoaktor mit einem mindestens den Piezoaktor umgebenden Schutzschichtsystem**

(30) Priorität: 01.02.2008 DE 102008007200
(71) Anmelder: ROBERT BOSCH GMBH, 70442 Stuttgart (DE)
(72) Erfinder: Schuett, Klaus-Volker, 73249, Wernau (DE); Cromme, Peter, 96050, Bamberg (DE); Klotz, Claudia, 96047, Bamberg (DE)

(57) **Zusammenfassung**

Es wird ein Piezoaktormodul (03) für eine von einem Medium umströmten Anordnung beschrieben, bestehend aus einem Aktorfuß (05) und einem Aktorkopf (04) und mindestens einem dazwischen eingefassten Piezoaktor (16) aus Piezoelementen (6), umfassend ein mindestens den Piezoaktor (16) umgebendes Schutzschichtsystem (17) aus einer oder mehreren funktionellen Schutzschichten, bei welchem Piezoaktormodul (03) mindestens eine Schutzschicht eine Barriereschutzschicht (18) aus einem graduierten Nanokomposit bestehend aus einer Matrix mit in der Matrix eingebetteten Füllstoffen umfasst, wobei sich der Füllstoffgehalt in der Matrix über die Dicke der Barriereschutzschicht (18) hinweg mit zunehmendem Abstand vom Piezoaktor (16) verändert. Darüber hinaus wird ein Piezoaktor (16) zur von einem Medium umströmten Anordnung, mit Piezoelementen (06) und mit einem Schutzschichtsystem (17) aus einer oder mehreren funktionellen Schichten beschrieben, bei dem mindestens eine Schutzschicht eine Barriereschutzschicht (18) aus einem graduierten Nanokomposit bestehend aus einer Matrix mit in der Matrix eingebetteten Füllstoffen umfasst, wobei sich der Füllstoffgehalt in der Matrix über die Dicke der Barriereschutzschicht (18) hinweg mit zunehmendem Abstand vom Piezoaktor (16) verändert.

## Beschreibung

### Stand der Technik

Die Erfindung betrifft ein Piezoaktormodul oder einen Piezoaktor nach den gattungsgemäßen Merkmalen der Ansprüche 1 oder 2.

Es ist an sich bekannt, dass zum Aufbau eines zuvor erwähnten Piezoaktors oder Piezoaktormoduls Piezoelemente so eingesetzt werden, dass unter Ausnutzung des sogenannten Piezoeffekts eine Steuerung des Nadelhubs eines Ventils oder dergleichen vorgenommen werden kann. Die Piezoelemente sind aus Piezolagen aus einem Material mit einer geeigneten Kristallstruktur so aufgebaut, dass bei Anlage einer äußeren elektrischen Spannung an Innenelektroden, die die Piezolagen jeweils einschließen, eine mechanische Reaktion der Piezoelemente erfolgt.

In Abhängigkeit von der Kristallstruktur und der Anlagebereiche der elektrischen Spannung stellt die mechanische Reaktion einen Druck oder Zug in eine vorgebbare Richtung dar. Derartige Piezoaktoren eignen sich beispielsweise für Anwendungen, bei denen Hubbewegungen unter hohen Betätigungskräften und hohen Taktfrequenzen ablaufen.

Piezoaktoren werden beispielsweise in Piezoinjektoren eingesetzt, welche zur zeitpunkt- und mengengenauen Dosierung von Kraftstoff in periodisch arbeitenden Verbrennungsmotoren verwendet werden.

Ein Piezoinjektor besteht im Wesentlichen aus einem Haltekörper und einem in dem Haltekörper angeordneten Piezoaktormodul, bestehend aus einem Kopf- und einem Fußteil sowie einem zwischen Kopf- und Fußteil angeordneten Piezoaktor aus einem oder mehreren Piezoelementen. Das Piezoaktormodul ist mit einer Düsennadel verbunden, sodass durch Anlegen oder Wegnahme einer Spannung an die Piezoelemente eine Düsenöffnung freigegeben oder verschlossen wird.

Bei der so genannten direkten Düsennadelsteuerung wird der Piezoaktor im Haltekörper des Piezoinjektors direkt im Kraftstoff unter Hochdruck betrieben. Ein Piezoinjektor mit direkter Düsennadelsteuerung ist beispielsweise aus der EP 117 46 15 A2 bekannt.

Zum Schutz des Piezoaktors bzw. der Piezoelemente vor Feuchtigkeit, etwa vor Diesel, Wasser, Raps-Methyl-Ester (RME) oder sonstigen elektrisch leitenden Substanzen, vor Partikeln und Schwebstoffen, vor den umgebenden hohen Drücken, sowie vor Druck- und Temperaturschwankungen ist es bekannt, den Piezoaktor in einem Piezoinjektor mit direkter Düsennadelsteuerung zumindest teilweise mit einer Schutzummantelung zu versehen.

Durch die WO 01/48834 A2 ist eine elektrische Isolation eines Piezoelements durch einen Schutzmantel aus Kunststoff bekannt, der beispielsweise durch Spritzgießen aufgebracht wird.

Ebenso ist bekannt, einen Piezoaktor eines Piezoaktormoduls gegen das umgebende Medium abzudichten, indem der Piezoaktor in einer stabilen Metallhülse gekapselt wird. An einer auch als aktive Stirnfläche bezeichneten Stirnfläche des Piezoaktors liegt ein Aktorkopf auf, welcher Hub und Kraft des Piezoaktors nach außen überträgt. Dieser Aktorkopf ist über eine Membran mit der stabilen Hülse verbunden. Dabei schafft die Membran eine flexible, aber dichte Verbindung zwischen Aktorkopf und Hülse. Diese Lösung ist für Anwendungen geeignet, bei denen sich der Piezoaktor bzw. das Piezoaktormodul im Niederdruckbereich eines Piezoinjektors befindet. Soll der Piezoaktor dagegen im Hochdruckbereich eingebracht werden, so erreicht diese Lösung sowohl hinsichtlich der Festigkeit der Membran, als auch hinsichtlich der Festigkeit der stabilen Hülse ihre Grenzen.

Durch die DE 102 17 361 A1 ist eine Lösung bekannt, bei der ein Piezoaktor an Teilen seiner Oberfläche zunächst mit einer organischen Basisschicht beschichtet ist. Diese ist wiederum mit einer anorganischen Deckschicht versehen, welche die Aufgabe hat, die Basisschicht gegenüber dem umgebenden Kraftstoff abzudichten, der ansonsten die organische Basisschicht angreifen würde. Weiterhin wird beschrieben, dass das Material für die organische Basisschicht vorzugsweise aus Naturkautschuk, Isopren, Butadien oder einem fluorierten Material bestehen soll.

Durch die WO 02/61856 A1 ist ferner eine Lösung bekannt, bei der ein Piezoaktormodul, bestehend aus einem Piezoaktor, einem Aktorfuss und einem Aktorkopf, zunächst mit einem Schrumpfschlauch lose überzogen wird, im Folgenden der Zwischenraum zwischen Schrumpfschlauch und Piezoelement mit einem Füllmaterial gefüllt wird, und schließlich der Schrumpfschlauch durch Wärmeeinwirkung geschrumpft wird und dadurch Piezoaktor und Füllmaterial dicht einschließt.

### Offenbarung der Erfindung

Die Erfindung geht von einem eingangs beschriebenen Piezoaktormodul oder einem Piezoaktor zur von einem flüssigen und/oder gasförmigen Medium umströmten Anordnung insbesondere in einem Piezoinjektor aus, wobei das Piezoaktormodul aus einem Aktorfuß und einem Aktorkopf und dazwischen eingefassten elektrisch kontaktierbaren Piezoelementen als Piezoaktor besteht. Es ist ein mindestens den Piezoaktor umgebendes Schutzschichtsystem aus einer oder mehreren funktionellen Schichten zur Verhinderung eines Eindringens des Mediums oder von Bestandteilen des Mediums in den Piezoaktor vorhanden. Erfindungsgemäß umfasst mindestens eine Schutzschicht eine Barriereschutzschicht aus einem graduierten Nanokomposit bestehend aus einer Matrix mit einem oder mehreren geeigneten, in der Matrix eingebetteten Füllstoffen, wobei sich der als Füllstoffgehalt bezeichnete Gehalt der in der Matrix eingebetteten Füllstoffe über die Dicke der Barriereschutzschicht hinweg mit zunehmendem Abstand vom Piezoaktor verändert.

Die Barriereschutzschicht schützt den Piezoaktor bzw. die Oberfläche des Piezoaktors vor dem umströmenden Medium, bei einer Anwendung in einem Piezoinjektor einem Kraftstoff bzw. dessen schädlichen Komponenten. Die Füllstoffe immobilisieren schädliche, durch Diffusion in das Basispolymer eindringende, insbesondere niedermolekulare Verbindungen, oder verlängern deren Diffusionswege.

Vorteile der Erfindung gegenüber dem Stand der Technik ergeben sich insbesondere dadurch, dass es durch eine erfindungsgemäße Graduierung der Füllstoffmenge und/oder Füllstoffart möglich ist, die vielfältigen Anforderungen an ein Schutzschichtsystem, wie etwa:
- Aufnehmen der dynamischen Hubbewegungen des Piezoaktors;
- Gute Haftung zwischen Oberfläche des Piezoaktors und der Barriereschicht;
- Anpassung des Wärmeausdehnungskoeffizienten;
- Hohe Permeationsbeständigkeit

in optimaler Weise durch einen veränderlichen Füllstoffgehalt zu erfüllen. Mit steigendem Füllstoffgehalt verändern sich die Eigenschaften des Komposits hinsichtlich Steifigkeit, Klebrigkeit, Wärmeausdehnungskoeffizienten und Permeation. Je höher der Füllstoffgehalt ist, desto höher ist die Steifigkeit, desto geringer ist die Klebrigkeit, desto kleiner ist der Wärmeausdehnungskoeffizient und desto permeationsdichter ist das Nanokomposit. Die Erfindung erlaubt eine gezielte Anpassung des Füllstoffgehalts des Nanokomposits der Barriereschutzschicht an die oben genannten Anforderungen.

Eine vorteilhafte Ausgestaltung der Erfindung sieht vor, dass sich der Füllstoffgehalt kontinuierlich ändert.

Eine andere vorteilhafte Ausgestaltung der Erfindung sieht vor, dass sich der Füllstoffgehalt diskontinuierlich, also in diskreten Schritten bzw. schrittweise ändert, sodass mit unterschiedlichem Abstand zum Piezoaktor Zonen mit unterschiedlichem Füllstoffgehalt ausgebildet sind.

Vorzugsweise nimmt der Füllstoffgehalt mit zunehmendem Abstand vom Piezoaktor zu. Ändert sich der Füllstoffgehalt beispielsweise kontinuierlich, ist an der Oberfläche des Piezoaktors der niedrigste bzw. ein niedriger Füllstoffgehalt vorgesehen, der dann mit zunehmendem Abstand von der Oberfläche des Piezoaktors zunimmt. Ändert sich der Füllstoffgehalt beispielsweise diskontinuierlich, so enthält die erste, direkt am Piezoaktor anliegende Zone des Nanokomposits der Barriereschutzschicht gar keinen bzw. nur einen sehr geringen Füllstoffgehalt, da sie eine gute Haftung zwischen Piezoaktor und Barriereschutzschicht sicherstellen muss sowie die dynamischen Hubbewegungen des Piezoaktors beschädigungsfrei aufnehmen muss. Die von Innen nach Außen auf die erste Zone darauffolgenden Zonen weisen jeweils einen höheren Füllstoffgehalt auf.

Die Füllstoffe umfassen vorzugsweise ein zumindest für den Piezoaktor schädliche Bestandteile des Mediums adsorbierendes und immobilisierendes Trocknungsmittel und/oder Adsorptionsmittel.

Gemäß einer bevorzugten Ausgestaltung der Erfindung umfassen die Füllstoffe Partikel mit einer Teilchengröße kleiner als 100 nm.

Vorzugsweise umfassen die Füllstoffe Zeolithe und/oder Schichtsilikate.

Vorzugsweise umfasst die Matrix ein Matrixmaterial auf Basis eines medienbeständigen Basispolymers.

Vorzugsweise umfasst die Matrix ein silikonmodifiziertes Perfluorether Gel und/oder ein fluoriertes Silikongel.

Besonders bevorzugt besteht die Matrix aus einem Polymer aus der Klasse der Epoxide.

### Kurze Beschreibung der Zeichnung

Ein Ausführungsbeispiel der Erfindung ist im Folgenden näher beschrieben. Es zeigen:
- Fig. 1: Eine schematische Darstellung eines Piezoinjektors in einem Längsschnitt.
- Fig. 2: Eine schematische Darstellung eines Piezoaktors mit einer aus einem graduierten Nanokomposit bestehenden Barriereschutzschicht in einem Querschnitt (Fig. 2a) und in einem Längsschnitt (Fig. 2b).

### Ausführungsform der Erfindung

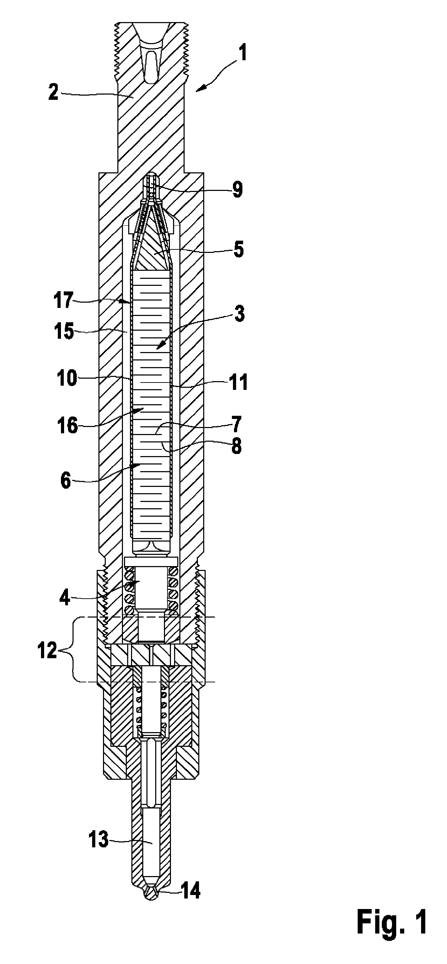

Ein in Fig. 1 dargestellter Piezoinjektor 01 umfasst im Wesentlichen einen Haltekörper 02 und einen in dem Haltekörper 02 angeordnetes Piezoaktormodul 03, das unter anderem einen Aktorkopf 04 und einen Aktorfuß 05 aufweist. Es sind dabei zwischen dem Aktorkopf 04 und dem Aktorfuß 05 mehrere übereinander gestapelte Piezoelemente 06 zur Bildung des eigentlichen Piezoaktors 16 vorhanden, die jeweils aus Piezolagen aus Piezokeramik und diese einschließende Innenelektroden 07 und 08 bestehen.

Die Innenelektroden 07 und 08 der Piezoelemente 06 sind mit Außenelektroden 10 und 11 und dann über ein Steckerteil 09 elektrisch kontaktiert. Das Piezoaktormodul 3 ist über einen Koppler 12 mit einer Düsennadel 13 verbunden. Durch Anlegen einer Spannung an die Piezoelemente 06 über die Innenelektroden 07 und 08 und die daraus folgende mechanische Reaktion wird, wie in der Beschreibungseinleitung erläutert, eine Düsenöffnung 14 freigegeben. Das Piezoaktormodul 03 wird bei der dargestellten Anwendung nach Fig. 1 als Piezoinjektor 01 in einem Raum 15 von einem mit dem Piezoinjektor 01 zu dosierenden Medium, typischerweise einem Kraftstoff für einen Verbrennungsmotor umströmt.

Der Piezoaktor 16 ist durch ein Schutzschichtsystem 17 vor dem Kraftstoff im Raum 15 bzw. vor schädlichen Bestandteilen des Kraftstoffs, wie etwa Wasser, RME oder sonstigen elektrisch leitenden Substanzen geschützt.

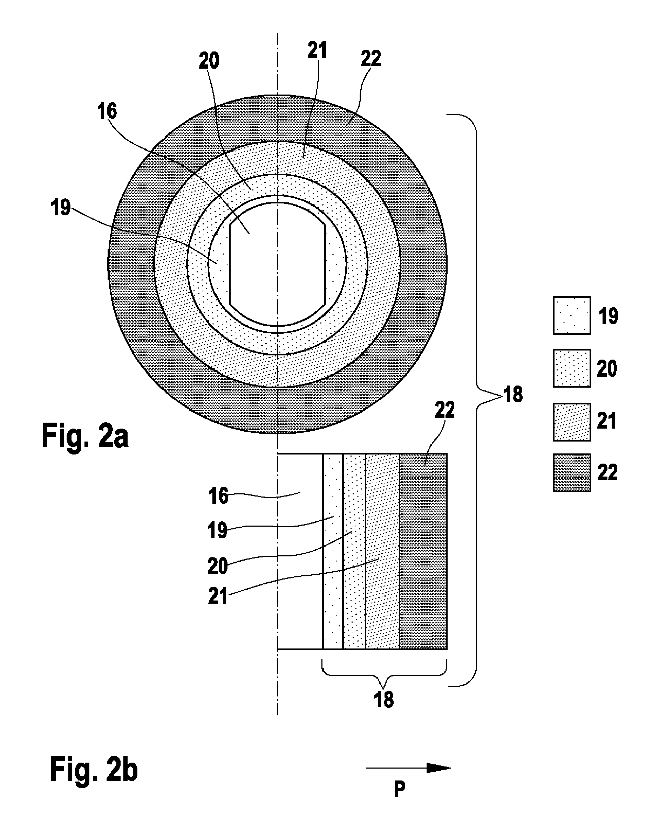

Das Schutzschichtsystem 17 besteht erfindungsgemäß aus einer oder mehreren funktionellen Schutzschichten, wobei mindestens eine Schutzschicht aus einem im Folgenden auch als Nanokomposit bzw. graduiertes Nanokomposit bezeichneten Gradientenwerkstoff auf Basis eines medienbeständigen Basispolymers bzw. Matrixwerkstoffes mit geeigneten Füllstoffen als in Fig. 2 dargestellte Barriereschutzschicht 18 für Piezoaktoren 16 in Kraftstoffumgebungen besteht.

Die Aufgabe der Barriereschutzschicht 18 besteht darin, den Piezoaktor 16 bzw. die Oberfläche des Piezoaktors 16 vor dem Kraftstoff bzw. dessen schädlichen Komponenten zu schützen. Da alle organischen Werkstoffe prinzipiell immer eine gewisse Diffusion insbesondere von niedermolekularen Verbindungen aufweisen, ist es die Aufgabe der Füllstoffe schädliche Verbindungen entweder zu immobilisieren, oder deren Diffusionswege zu verlängern.

Durch eine erfindungsgemäße Graduierung der Füllstoffmenge und/oder Füllstoffart ist es möglich, die vielfältigen Anforderungen an ein Schutzschichtsystem in optimaler Weise zu erfüllen. Diese Anforderungen sind beispielsweise:
- Aufnehmen der dynamischen Hubbewegungen des Piezoaktors;
- Gute Haftung zwischen Oberfläche des Piezoaktors und der Barriereschicht;
- Anpassung des Wärmeausdehnungskoeffizienten;
- Hohe Permeationsbeständigkeit.

Ein wesentlicher Vorteil der Erfindung liegt in der einfachen Erfüllung der Aufgabe der Barriereschutzschicht 18.

Erfindungsgemäß besteht die Barriereschutzschicht 18 aus einem graduierten Nanokomposit.

Ein Nanokomposit setzt sich zusammen aus Partikeln mit einer Teilchengröße kleiner als 100 nm, den sogenannten Füllstoffen, die vorzugsweise aus Zeolithen und/oder Schichtsilikaten bestehen, und einer weiteren Komponente, der sogenannten Matrix. Die Matrix besteht vorzugsweise aus einem silikonmodifizierten Perfluorether Gel oder einem fluorierten Silikongel oder einem Polymer aus der Klasse der Epoxide. Die Füllstoffe sind in der Matrix eingebettet.

Ein graduiertes Nanokomposit weist Zonen oder Bereiche mit unterschiedlichen, der Graduierung entsprechenden Füllstoffgehalten auf.

Mit steigendem Füllstoffgehalt verändern sich die Eigenschaften des Komposits hinsichtlich Steifigkeit, Klebrigkeit, Wärmeausdehnungskoeffizienten und Permeation. Je höher der Füllstoffgehalt ist, desto höher ist die Steifigkeit, desto geringer ist die Klebrigkeit, desto kleiner ist der Wärmeausdehnungskoeffizient und desto permeationsdichter ist das Nanokomposit.

Vorzugsweise bilden die unterschiedlichen Graduationen des Nanokomposits innerhalb der Barriereschutzschicht 18 unterschiedlich graduierte Zonen 19, 20, 21, 22 mit unterschiedlichen Füllstoffgehalten.

Die erste Zone 19 des Gradientenwerkstoffes der Barriereschutzschicht 18, die direkt am Piezoaktor 16 anliegt, muss eine gute Haftung zwischen Piezoaktor 16 und Barriereschutzschicht 18 sicherstellen sowie die dynamischen Hubbewegungen des Piezoaktors beschädigungsfrei aufnehmen. Vorzugsweise enthält die erste Zone 19 demnach gar keinen bzw. nur einen sehr geringen Füllstoffgehalt. Die von Innen nach Außen auf die erste Zone 19 darauffolgenden Zonen 20, 21, 22 weisen jeweils einen höheren Füllstoffgehalt auf.

Ebenfalls ist denkbar, dass der Füllstoffgehalt vorzugsweise kontinuierlich über die Barriereschutzschicht 18 von Innen nach Außen erhöht wird. Dabei ist an der Oberfläche des Piezoaktors 16 der niedrigste bzw. ein niedriger Füllstoffgehalt vorgesehen, der dann mit zunehmendem Abstand von der Oberfläche des Piezoaktors 16 zunimmt.

Demnach ist im Wesentlichen zwischen zwei unterschiedliche Graduierungen zu unterscheiden:
a) einer Graduierung in diskreten Schritten, wobei vorzugsweise gilt: Füllstoffgehalt erste Zone 19 < Füllstoffgehalt zweite Zone 20 < Füllstoffgehalt dritte Zone 21 < Füllstoffgehalt vierte Zone 22 usw.
b) einer kontinuierlichen Graduierung bei der sich der Füllstoffgehalt kontinuierlich über die Barriereschutzschicht 18 hinweg verändert. Dabei nimmt der Füllstoffgehalt vorzugsweise von Innen nach Außen kontinuierlich zu, bzw. wird vorzugsweise von Innen nach Außen erhöht.

Der Fall a) kann durch mehrfaches werkzeuggebundenes Umspritzen und/oder Umgießen mit unterschiedlich großen Formen verwirklicht werden. Der Fall A ist in Fig. 2 dargestellt, wobei der Pfeil P von Innen nach Außen sukzessive zunehmende Füllstoffgehalte der Zonen 19, 20, 21, 22 angibt.

Für den Fall b) ist beispielsweise ein Schleudergussverfahren denkbar, bei dem das Basispolymer mit variierendem Füllstoffgehalt in eine rotierende Gussform gefüllt wird. Durch die Zentrifugalkraft wird das gefüllte Polymer an die Außenform des Gussform gepresst, wodurch eine Barriereschutzschicht mit sich über die Dicke der Barriereschutzschicht kontinuierlich veränderndem Füllstoffgehalt, ohne Zonen mit diskreten Füllstoffgehalt-Stufen. Durch einen derartigen Aufbau können sehr hohe Füllstoffgehalte mit entsprechend geringen Permeationsraten in den äußeren, am weitesten vom Piezoaktor 16 beabstandeten Zonen der Barriereschutzschicht 18 verwirklicht werden.

Demgegenüber können Barriereschutzschichten mit hohem Füllstoffgehalt aufgrund der hohen Scherbelastungen auf der Oberfläche des Piezoaktors und aufgrund der im Vergleich zu einem füllstofffreien Polymer herabgesetzten bzw. verringerten Haftfestigkeit nicht als alleinige Barriereschicht auf dem Piezoaktor verwirklicht werden.

Ein weiterer Vorteil einer Barriereschutzschicht 18 aus einem Gradientenwerkstoff ist die Möglichkeit, den Wärmeausdehnungskoeffizienten der Barriereschutzschicht 18 an der Grenzfläche zum Piezoaktor 16 oder zu einer weiteren Schutzschicht durch einen entsprechenden Füllstoffgehalt gezielt anpassen zu können.

Wichtig ist hervorzuheben, dass die Gesamt-Anzahl der Zonen 19, 20, 21, 22 durchaus auch von vier abweichen kann. Es können je nach Einsatzbereich und Anwendungsfall weniger oder auch mehr als vier Zonen 19, 20, 21, 22 vorgesehen sein.

## Patentansprüche

1. Piezoaktormodul (03) zur von einem Medium umströmten Anordnung, bestehend aus einem Aktorfuß (05) und einem Aktorkopf (04) und mindestens einem dazwischen eingefassten Piezoaktor (16) aus Piezoelementen (6), umfassend ein mindestens den Piezoaktor (16) umgebendes Schutzschichtsystem (17) aus einer oder mehreren funktionellen Schutzschichten, **dadurch gekennzeichnet, dass** mindestens eine Schutzschicht eine Barriereschutzschicht (18) aus einem graduierten Nanokomposit bestehend aus einer Matrix mit in der Matrix eingebetteten Füllstoffen umfasst, wobei sich der Füllstoffgehalt in der Matrix über die Dicke der Barriereschutzschicht (18) hinweg mit zunehmendem Abstand vom Piezoaktor (16) verändert.

2. Piezoaktor (16) zur von einem Medium umströmten Anordnung, mit Piezoelementen (06) und mit einem Schutzschichtsystem (17) aus einer oder mehreren funktionellen Schichten, **dadurch gekennzeichnet, dass** mindestens eine Schutzschicht eine Barriereschutzschicht (18) aus einem graduierten Nanokomposit bestehend aus einer Matrix mit in der Matrix eingebetteten Füllstoffen umfasst, wobei sich der Füllstoffgehalt in der Matrix über die Dicke der Barriereschutzschicht (18) hinweg mit zunehmendem Abstand vom Piezoaktor (16) verändert.

3. Piezoaktormodul oder Piezoaktor nach Anspruch 1 oder 2, **dadurch gekennzeichnet, dass** sich der Füllstoffgehalt kontinuierlich ändert.

4. Piezoaktormodul oder Piezoaktor nach Anspruch 1 oder 2, **dadurch gekennzeichnet, dass** sich der Füllstoffgehalt diskontinuierlich ändert, sodass mit unterschiedlichem Abstand zum Piezoaktor Zonen (19, 20, 21, 22) mit unterschiedlichem Füllstoffgehalt ausgebildet sind.

5. Piezoaktormodul oder Piezoaktor nach einem der vorhergehenden Ansprüche, **dadurch gekennzeichnet, dass** der Füllstoffgehalt mit zunehmendem Abstand vom Piezoaktor (16) zunimmt.

6. Piezoaktormodul oder Piezoaktor nach einem der vorhergehenden Ansprüche, **dadurch gekennzeichnet, dass** die Füllstoffe ein zumindest für den Piezoaktor (16) schädliche Bestandteile des Mediums adsorbierendes und immobilisierendes Trocknungsmittel und/oder Adsorptionsmittel umfassen.

7. Piezoaktormodul oder Piezoaktor nach einem der vorhergehenden Ansprüche, **dadurch gekennzeichnet, dass** die Füllstoffe Partikel mit einer Teilchengröße kleiner als 100 nm umfassen.

8. Piezoaktormodul oder Piezoaktor nach einem der vorhergehenden Ansprüche, **dadurch gekennzeichnet, dass** die Füllstoffe Zeolithe umfassen.

9. Piezoaktormodul oder Piezoaktor nach einem der vorhergehenden Ansprüche, **dadurch gekennzeichnet, dass** die Füllstoffe Schichtsilikate umfassen.

10. Piezoaktormodul oder Piezoaktor nach einem der vorhergehenden Ansprüche, **dadurch gekennzeichnet, dass** die Matrix ein Matrixmaterial auf Basis eines medienbeständigen Basispolymers umfasst.

11. Piezoaktormodul oder Piezoaktor nach einem der vorhergehenden Ansprüche, **dadurch gekennzeichnet, dass** die Matrix aus einem silikonmodifizierten Perfluorether Gel besteht.

12. Piezoaktormodul oder Piezoaktor nach einem der Ansprüche 1 bis 10, **dadurch gekennzeichnet, dass** die Matrix aus einem fluorierten Silikongel besteht.

13. Piezoaktormodul oder Piezoaktor nach einem der vorhergehenden Ansprüche, **dadurch gekennzeichnet, dass** die Matrix aus einem Polymer aus der Klasse der Epoxide besteht.
